Europäisches Patentamt

European Patent Office

Office européen des brevets

(19)

(11) EP 1 598 876 A1

(12) **EUROPEAN PATENT APPLICATION**
published in accordance with Art. 158(3) EPC

(43) Date of publication:
**23.11.2005 Bulletin 2005/47**

(51) Int Cl.⁷: **H01L 43/06**

(21) Application number: **04714881.2**

(22) Date of filing: **26.02.2004**

(86) International application number:
**PCT/JP2004/002258**

(87) International publication number:
**WO 2004/077585 (10.09.2004 Gazette 2004/37)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **26.02.2003 JP 2003049891**

(71) Applicant: **Asahi Kasei Electronics Co., Ltd. Tokyo 160-0023 (JP)**

(72) Inventors:
• **SHIBATA, Yoshihiko**
  **Fuji-shi, Shizuoka 416-0921 (JP)**
• **ISE, Shuji**
  **Nobeoka-shi, Miyazaki 882-0863 (JP)**

(74) Representative: **Kramer - Barske - Schmidtchen European Patent Attorneys Patenta Radeckestrasse 43 81245 München (DE)**

(54) **SEMICONDUCTOR SENSOR AND METHOD FOR MANUFACTURING SAME**

(57)    The present invention relates to a semiconductor sensor and method for manufacturing same, which makes it possible to form on a Si substrate an InSb or InAs film having a high electron mobility and a comparatively high sheet resistance, and to provide a highly sensitive, low power consumption, high quality element industrially. On a (111) Si substrate (1), a first compound semiconductor layer (2) composed of at least two elements selected from the group of Ga, Al, In, As, Sb and P is formed, and on the first compound semiconductor layer (2), an InSb or InAs layer is formed as a second compound semiconductor layer (3), thereby being able to achieve a high electron mobility, high resistance film with a thickness of about 1μm. A Hall element is formed by using the resultant thin film, which makes it possible to form a highly sensitive, comparatively high resistance element.

FIG.1

EP 1 598 876 A1

**Description**

TECHNICAL FIELD

The present invention relates to a semiconductor sensor such as a magnetic sensor and method for manufacturing same, and more particularly to a semiconductor sensor and method for manufacturing same, which semiconductor sensor includes an on-Si compound semiconductor and is applicable to compound semiconductor magnetic sensors and electronic devices having an active layer of InSb or the like.

BACKGROUND ART

Recently, Hall elements, which are a magnetic sensor, have been employed in a wide field from position detection of magnetic poles of brushless motors to applications for driving a DVD-ROM or VTR, and for mobile phones and automobiles. In particular, highly sensitive, low-cost Hall elements with comparatively low power consumption have expanded the needs of the marketplace.

Generally, the sensitivity of a Hall element is proportional to the electron mobility of its material, that is, a semiconductor material, and the input resistance of the Hall element is proportional to the sheet resistance of the material. Although the input resistance and the sensitivity of the Hall element are controllable by the design, they have a trade-off relationship between them. Accordingly, to construct a highly sensitive, high input resistance element, a material with high electron mobility and high sheet resistance is required. The relation between the electron mobility $\mu$, sheet resistance Rs and sheet carrier concentration Ns is expressed by the following expression.

$$1/(Rs \times \mu) = Ns \times e$$

where "e" is the electric charge. Accordingly, to form a material with high electron mobility $\mu$ and high sheet resistance Rs, the sheet carrier concentration Ns must be reduced.

Conventionally, InSb, InAs, GaAs and the like having comparatively high electron mobility have been used as a Hall element material. In particular, bulk single crystal InSb with high electron mobility of 75000 $cm^2$/Vs is favorable for constructing a highly sensitive element.

Normally, since the bulk single crystal growth of InSb or InAs is difficult, the element is produced by forming thin films of these materials on a substrate. In this case, inferior quality films will cause carriers which increase the sheet carrier concentration, thereby resulting in impracticable Hall elements. Furthermore, increasing the thickness of the films to ameliorate the film quality and thus to improve the electron mobility will increase the sheet carrier concentration, which is also impracticable.

To achieve a highly sensitive Hall element with comparatively low power consumption, it is necessary to form a high quality thin film with a thickness of about 1 $\mu$m, and with a sheet carrier concentration equal to or less than $2\times$E12/$cm^2$. Thus, GaAs which has the same crystal structure as the InSb and InAs has been used as the substrate conventionally. In this case, good films with a thickness of 1 $\mu$m, and with the sheet carrier concentration of about $2\times$E12/$cm^2$ have been obtained.

However, since the GaAs substrate is expensive and heavy, the process equipment used in the LSI process can be seldom used. In addition, since the substrate is polished for producing the element, its shavings are unfavorable for the environment.

If a Si substrate can be used, the foregoing problems are all solved. In addition, it brings about great merit because it enables a monolithic construction of an IC and a magnetic sensor. However, no quality films have been achieved on the Si substrate. This is probably because Si has a crystal structure different from that of InSb or InAs. Japanese Patent Application Laid-open No. 11-251657 (1999) describes that a high resistance film can be achieved by forming InSb on a (111) GaAs and on a (111) Si substrate, for example. It also describes that forming an InSb film on (111) GaAs enables a high resistance, highly sensitive magnetic sensor.

However, the inventors of the present invention confirmed that no high electron mobility film could be achieved as a result of forming a 1 $\mu$m thick InSb film directly on a (111) Si according to the above-mentioned Japanese Patent Application Laid-open No. 11-251657 (1999).

In addition, an InSb film on the (111) Si, and a magnetic sensor using it have been known before the application of the above-mentioned Japanese Patent Application Laid-open No. 11-251657 (1999), and a report is present that a highly sensitive magnetic sensor is achieved (for example, "National Technical Report" 1996, Vol. 42, No. 4, pp. 84-92). However, to achieve the highly sensitive film, InSb is formed 3 $\mu$m or more in thickness, which suggests that it is difficult to form a highly sensitive, high resistance element.

The present invention is implemented to solve the foregoing problems. Therefore it is an object of the present invention to provide a highly sensitive, low power consumption, high quality semiconductor sensor and its fabrication method by enabling the formation of a high electron mobility InSb or InAs film with a comparatively high sheet resistance on a Si substrate.

DISCLOSURE OF THE INVENTION

As a result of study, the inventors of the present invention found that a high electron mobility, high resistance film of about 1 $\mu$m in thickness could not be achieved by directly forming InSb or InAs on a (100) Si or (111) Si substrate as in the prior art because of small sheet carrier concentration, but that a high electron mobility, high resistance film having a thickness of about 1 μm and a sheet carrier concentration equal to or less than $2\times E12/cm^2$ couldbe achieved by forming a first compound semiconductor layer composed of at least two elements selected from the group of Ga, Al, In, As, Sb and P on a (111) Si substrate, and then by forming InSb or InAs thereon.

The reason why such a phenomenon does not occur on the (100) Si, but is achieved on the (111) Si is very likely to result from the difference in the number of bonds on a Si surface.

Although defects occur between the (111) Si and the first compound semiconductor layer because of the difference in the crystal structure, the adverse effect of the defects does not reach a second compound semiconductor. This is considered to be the reason why a high quality film can be achieved in spite of the difference between the lattice spacings between the first compound semiconductor and the second compound semiconductor usually amounting to 5% or more. Furthermore, we formed a Hall element using the resultant thin film, and confirmed that a highly sensitive, comparatively high resistance element could be formed, thereby implementing the present invention.

To accomplish the object of the present invention, on a Si substrate whose (111) plane is parallel to a surface of the substrate, a first compound semiconductor layer composed of at least two elements selected from the group of Ga, Al, In, As, Sb and P is formed, and on the first compound semiconductor layer, a second compound semiconductor layer composed of $In_xGal_{1-x}As_ySb_{1-y}$ ($0<x\leq1.0$, $0\leq y\leq1.0$), and more preferably composed of $In_xGa_{1-x}As_ySb_{1-y}$ ($0.5\leq x\leq1.0$, $0\leq y\leq1.0$), is formed. As a result, the (111) plane of the first compound semiconductor layer and that of the second compound semiconductor become parallel to the surface of the substrate.

The second compound semiconductor layer operates as a functional layer. In addition, electrodes are formed at both edges of the second compound semiconductor layer so that a current flows in a direction within a plane of the second compound semiconductor layer.

The first compound semiconductor layer is preferably composed of $Al_{1-z}Ga_zAs$ ($0\leq z\leq1$), and the second compound semiconductor layer is preferably composed of $InAs_ySb_{1-y}$ ($0\leq y\leq1$). The second compound semiconductor layer may be doped with one of Si and Sn impurities.

The second compound semiconductor layer is preferably covered with a passivation film except for contact portions with the electrodes.

The semiconductor sensor is fabricated by forming, on a Si substrate whose (111) plane is parallel to a surface of the substrate, a first compound semiconductor layer that is composed of at least two elements selected from the group of Ga, Al, In, As, Sb and P; by forming, on the first compound semiconductor layer, a second compound semiconductor layer composed of $In_xGa_{1-x}As_ySb_{1-y}$ ($0<x\leq1.0$, $0\leq y\leq1.0$); and by forming electrodes on the second compound semiconductor layer. The second compound semiconductor layer may be doped with one of Si and Sn impurities.

BRIEF DESCRIPTION OF THE DRAWINGS

FIG. 1 is a schematic cross sectional view showing a stacked body including on-Si compound semiconductor layers in accordance with the present invention;
FIG. 2 is a schematic cross sectional view showing a structure of a magnetic sensor using the stacked body of FIG. 1; and
FIG. 3 is a graph illustrating an X-ray diffraction result of the compound semiconductor layer.

BEST MODE FOR CARRYING OUT THE INVENTION

The best mode for carrying out the invention will now be described with reference to the accompanying drawings.

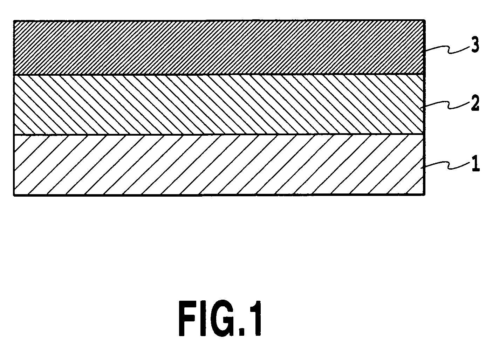

FIG. 1 is a schematic cross sectional view showing a stacked body including on-Si compound semiconductor layers in accordance with the present invention. In FIG. 1, the reference numeral 1 designates a (111) Si substrate, 2 designates a first compound semiconductor layer, and 3 designates a second compound semiconductor layer.

The stacked body includes the first compound semiconductor layer 2 formed on the Si substrate 1 whose (111) plane is parallel to the surface of the substrate, and the second compound semiconductor layer 3 formed on the first compound semiconductor layer 2. The first compound semiconductor layer 2 is composed of at least two elements selected from the group of Ga, Al, In, As, Sb and P, and the second compound semiconductor layer 3 is composed of $In_xGa_{1-x}As_ySb_{1-y}$ ($0<x\leq1.0$, $0\leq y\leq1.0$). The first compound semiconductor layer 2 and the second compound semiconductor layer 3 each have the (111) plane parallel to the surface of the substrate.

As for the substrate 1, it must consist of (111) Si, and a substrate with (111)±10 degrees is usually used.

As for the first compound semiconductor layer 2, it consists of a compound semiconductor composed of at least two elements selected from the group of Ga, Al, In, As, Sb and P, and its thickness is usually from 0.01 μm to 10 μm, and is preferably from 0.1 μm to 5 μm, and more preferably from 0.5 μm to 2 μm. $Al_{1-z}Ga_zAs$ ($0\leq z\leq1$) is a preferable example of the first compound semiconductor layer 2, and GaAs is a particularly preferable example.

As for the second compound semiconductor layer 3, it is composed of $In_xGa_{1-x}As_ySb_{1-y}$ ($0≤y≤1$), and its thickness is usually equal to or greater than 0.1 μm. As its thickness increases, the sheet resistance is reduced. To form a highly sensitive Hallelement with a comparatively high resistance, the thickness is usually from 0.15 μm to 2 μm, and preferably from 0.3 μm to 1.5 μm, and more preferably from 0.5 μm to 1.2 μm. $InAs_ySb_{1-y}$ ($0≤y≤1$) is a preferable example as the second compound semiconductor layer 3, and InSb or InAs is a particularly preferable example.

The second compound semiconductor layer 3 may be doped with impurities. As doped elements, Si or Sn is a preferable example. The impurity concentration is usually from $1×E15/cm^3$ to $3.5×E16/cm^3$, preferably from $2×E15/cm^3$ to $2.5×E16/cm^3$, and more preferably from $5×E15/cm^3$ to $2×E16/cm^3$.

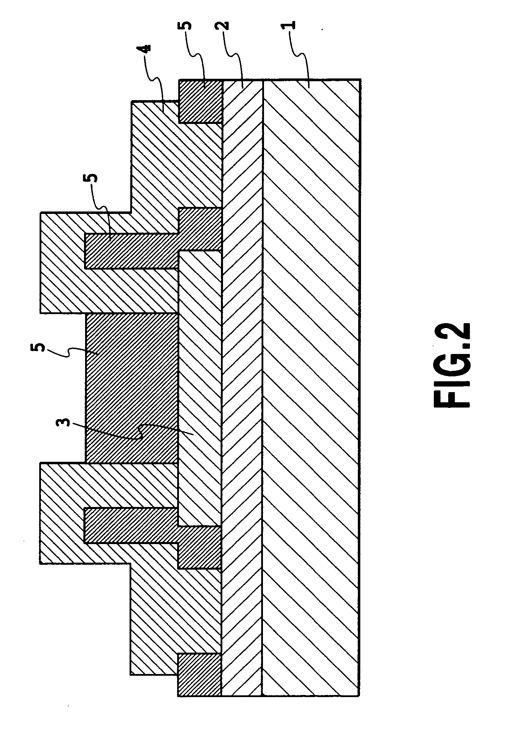

FIG. 2 is a schematic cross sectional view showing a structure of a magnetic sensor using the stacked body of FIG. 1. In FIG. 2, the reference numeral 4 designates a metal electrode layer, and 5 designates a protective layer (passivation film). The components having the same function as those of FIG. 1 are designated by the same reference numerals.

The magnetic sensor has, on the Si substrate 1 whose (111) plane is parallel to the surface of the substrate, the first compound semiconductor layer 2 composed of at least two elements selected from the group of Ga, Al, In, As, Sb and P. On the first compound semiconductor layer 2, the second compound semiconductor layer 3 composed of $In_xGa_{1-x}As_ySb_{1-y}$ ($0.5≤x≤1.0$, $0≤y≤1.0$) is disposed in such a manner that the (111) plane of the first compound semiconductor layer 2 and that of the second compound semiconductor layer 3 are parallel to the surface of the substrate. In addition, at both edges on the second compound semiconductor layer 3, the metal electrode layer 4 is formed. The second compound semiconductor layer 3 is covered with the protective layer 5 (passivation film) except for contact portions with the metal electrode layer 4.

The metal electrode layer 4 constituting the magnetic sensor usually forms ohmic electrodes, which preferably make ohmic contact with a sensor layer. As for the material of the electrodes, it may be known multilayer electrodes such as AuGe/Ni/Au, or a single layer metal.

As for the passivation film, SiN, SiON or $SiO_2$ is a preferable example. The magnetic sensor in accordance with the present invention includes a Hall element and a magneto-resistance device.

[EXAMPLE 1]

First, on a 2-inch diameter (111) Si substrate, a 700 nm GaAs layer as the first compound semiconductor layer 2, and a 1 μm InSb layer as the second compound semiconductor layer 3 were successively formed by the molecular beam epitaxy (MBE).

It was confirmed by the X-ray diffraction method that the (111) planes of the first compound semiconductor layer 2 and of the second compound semiconductor layer 3 were parallel to the surface of the substrate 1.

Electrical characteristics were measured using a van der Pauw method. As a result, it was found that high quality characteristics were achieved in which the sheet carrier concentration was $1.7E12/cm^2$ and the electron mobility was 37000 or more.

[COMPARATIVE EXAMPLE 1]

First, on a 2-inch diameter (111) Si substrate, an InSb film of 1 μm thick was directly formed by the molecular beam epitaxy (MBE).

The electrical characteristics were measured using the van der Pauw method. As a result, it was found that the sheet carrier concentration was large such as $3.1×E12/cm^2$, and the electron mobility was only 11000 $cm^2/Vs$.

[EXAMPLE 2]

Next, on the stacked layer substrate formed in the above-mentioned example 1, a Hall element, a magnetic sensor similar to that as shown in FIG. 2, was formed by photolithography, and the Hall element characteristics were measured. As for the electrodes, a 100 nm Ti layer and a 600 nm Au layer were successively deposited by the vacuum evaporation. The chip size of the Hall element was 360 μm × 360 μm. Three structures with different design were formed simultaneously, and the characteristics of the individual elements with these design structures were estimated by applying 1 Vinput voltage in 50 mT magnetic field. Table 1 shows the results.

TABLE 1

| Design | Vh (mV) | Rin (Ω) |
|--------|---------|---------|
| A | 112 | 166 |
| B | 62 | 301 |
| C | 53 | 351 |

The design B ensures that a low power consumption, highly sensitive Hall element can be formed with a large element resistance of 300 Ω or more and a high sensitivity of 60 mV or more. According to the design, a higher sensitivity can be achieved at the cost of reducing the resistance (design A), or a higher resistance can be achieved at the cost of reducing the sensitivity (design C). In any case, since the sheet carrier concentration of the material is good such as $1.7E12/cm^2$, the flexibility of the design is large so that a highly sensitive, high resistance element design can be implemented.

[COMPARATIVE EXAMPLE 2]

Next, on the InSb film formed in the comparative example 1, a Hall element was formed using the photolithography as in the example 2, and its characteristics were estimated. Table 2 shows the results.

TABLE 2

| design | Vh (mV) | Rin ($\Omega$) |
|--------|---------|------|
| A | 33 | 302 |
| B | 18 | 549 |
| C | 16 | 641 |

The design A indicates that the element resistance is approximately equal to that of the design B of the example 2. However, it was confirmed that the sensitivity in this case was 33 mV, about 50% of 62 mV of the example 2. Since there is a trade-off between the sensitivity and the resistance, a design is not impossible to increase the sensitivity beyond 33 mV. However, since the element resistance is reduced in this case, it is impossible to form a highly sensitive, high resistance element as compared with the example. The reason for this is that since the sheet carrier concentration of the material is large such as $3.1 \times E12/cm^2$, there is little design flexibility.

[EXAMPLE 3]

On a 2-inch diameter (111) Si substrate, a 700 nm GaAs layer as the first compound semiconductor layer 2, and a 0.7 $\mu$m InSb layer as the second compound semiconductor layer 3 were successively formed by the molecular beam epitaxy (MBE). During the formation of the InSb film, 2-step growth was carried out.

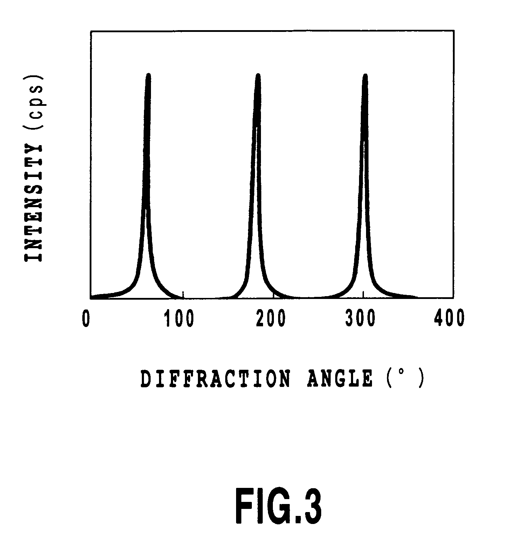

It was confirmed by the X-ray diffraction method that the (111) planes of the first compound semiconductor layer 2 and of the second compound semiconductor layer 3 are parallel to the surface of the substrate. The single crystal structure was confirmed by measuring the (220) plane of InSb. FIG. 3 illustrates the result. Three peaks appear at 120 degree intervals, which confirms that the single crystal film was formed.

Electrical characteristics were measured using the van der Pauw method. As a result, it was found that high quality characteristics were achieved in which the sheet carrier concentration was 1. 0E12/cm$^2$ and the electron mobility was 48000 cm$^2$/Vs.

Next, on the second compound semiconductor, a Hall element, a magnetic sensor similar to that as shown in FIG. 2, was formed by photolithography, and the Hall element characteristics were measured. As for the electrodes, a 100 nm Ti layer and a 600 nm Au layer were successively deposited by the vacuum evaporation. The chip size of the Hall element was 360 $\mu$m $\times$ 360 $\mu$m. Three structures with different design were formed simultaneously, and the characteristics of the individual elements with these design structures were estimated by applying 1 V input voltage in 50 mT magnetic field. Table 3 shows the results.

The design B ensures that a low power consumption, highly sensitive Hall element with a large element resistance of 300 $\Omega$ or more and a high sensitivity of 80 mV can be formed. According to the design, a higher sensitivity can be achieved at the cost of reducing the resistance (design A), or a higher resistance can be achieved at the cost of reducing the sensitivity (design C). In any case, since the sheet carrier concentration of the material is good such as 1.0E12/cm$^2$, the flexibility of the design is large so that a highly sensitive, high resistance element design can be implemented.

TABLE 3

| design | Vh (mV) | Rin ($\Omega$) |
|--------|---------|------|
| A | 145 | 215 |
| B | 80 | 390 |
| C | 69 | 455 |

INDUSTRIAL APPLICABILITY

On a Si substrate whose (111) plane is parallel to a surface of the substrate, a first compound semiconductor layer composed of at least two elements selected from the group of Ga, Al, In, As, Sb and P is formed, and on the first compound semiconductor layer, a second compound semiconductor layer composed of $In_xGa_{1-x}As_ySb_{1-y}$ ($0<x\leq1.0$ , $0\leq y\leq1.0$) is formed. Accordingly, the (111) plane of the first compound semiconductor layer and that of the second compound semiconductor become parallel to the surface of the substrate, thereby being able to form on the Si substrate an InSb or InAs film having a high electron mobility and a comparatively high sheet resistance. As a result, a highly sensitive, low power consumption, high quality element can be provided industrially by using a cheaper, more versatile and more environmentally friendly Si substrate than the GaAs substrate.

**Claims**

**1.** A semiconductor sensor comprising:

a first compound semiconductor layer that is formed on a Si substrate whose (111) plane is parallel to a surface of the substrate, and that is composed of at least two elements selected from the group of Ga, Al, In, As, Sb and P;

a second compound semiconductor layer that is formed on said first compound semiconductor layer, and is composed of $In_xGa_{1-x}Sb_{1-y}$ ($0<x\leq1.0$, $0\leq y\leq1.0$), and that operates as a functional layer; and

electrodes that are formed at both edges of said second compound semiconductor layer so that a current flows in a direction within a plane of said second compound semiconductor layer.

2. The semiconductor sensor as claimed in claim 1, wherein (111) planes of said first compound semiconductor layer and of said second compound semiconductor layer are parallel to the surface of said substrate.

3. The semiconductor sensor as claimed in claim 1, wherein said first compound semiconductor layer is composed of $Al_{1-z}Ga_zAs$ ($0 \leq z \leq 1$).

4. The semiconductor sensor as claimed in claim 1, wherein said second compound semiconductor layer is composed of $In_xGa_{1-x}As_ySb_{1-y}$ ($0.5 \leq x \leq 1.0$, $0 \leq y \leq 1.0$).

5. The semiconductor sensor as claimed in claim 4, wherein said second compound semiconductor layer is composed of $InAs_ySb_{1-y}$ ($0 \leq y \leq 1$).

6. The semiconductor sensor as claimed in claim 1, wherein said second compound semiconductor layer is equal to or greater than 0.15 $\mu$m, and equal to or less than 2 $\mu$m in thickness.

7. The semiconductor sensor as claimed in claim 1, wherein said second compound semiconductor layer is doped with an impurity.

8. The semiconductor sensor as claimed in claim 6, wherein said impurity is one of Si and Sn.

9. The semiconductor sensor as claimed in claim 1, wherein said second compound semiconductor layer is covered with a passivation film except for contact portions with said electrodes.

10. The semiconductor sensor as claimed in claim 1, wherein said second compound semiconductor layer is a magnetically sensitive layer constituting a sensor for detecting magnetic flux density.

11. A fabrication method of a semiconductor sensor comprising the steps of:

forming, on a Si substrate whose (111) plane is parallel to a surface of the substrate, a first compound semiconductor layer that is composed of at least two elements selected from the group of Ga, Al, In, As, Sb and P;
forming, on said first compound semiconductor layer, a second compound semiconductor layer composed of $In_xGa_{1-x}As_ySb_{1-y}$ ($0 < x \leq 1.0$,

$0 \leq y \leq 1.0$); and

forming a plurality of electrodes on said second compound semiconductor layer.

12. The fabrication method of the semiconductor sensor as claimed in claim 10, wherein said first compound semiconductor layer is composed of $Al_{1-z}Ga_zAs$ ($0 \leq z \leq 1$).

13. The fabrication method of the semiconductor sensor as claimed in claim 10, wherein said second compound semiconductor layer is composed of $In_xGa_{1-x}As_ySb_{1-y}$ ($0.5 \leq x \leq 1.0$, $0 \leq y \leq 1.0$).

14. The fabrication method of the semiconductor sensor as claimed in claim 13, wherein said second compound semiconductor layer is composed of $InAs_y \cdot Sb_{1-y}$ ($0 \leq y \leq 1$).

15. The fabrication method of the semiconductor sensor as claimed in claim 10, wherein said second compound semiconductor layer is equal to or greater than 0.15 $\mu$m, and equal to or less than 2 $\mu$m in thickness.

16. The fabrication method of the semiconductor sensor as claimed in claim 10, wherein said second compound semiconductor layer is doped with one of Si and Sn impurities.

# FIG.1

EP 1 598 876 A1

FIG.2

FIG.3

## INTERNATIONAL SEARCH REPORT

| | International application No. |
|---|---|
| | PCT/JP2004/002258 |

**A. CLASSIFICATION OF SUBJECT MATTER**
    Int.Cl$^7$  H01L43/06

According to International Patent Classification (IPC) or to both national classification and IPC

**B. FIELDS SEARCHED**

Minimum documentation searched (classification system followed by classification symbols)
    Int.Cl$^7$  H01L43/06, G01R33/07, G11B5/37

Documentation searched other than minimum documentation to the extent that such documents are included in the fields searched
    Jitsuyo Shinan Koho        1922-1996    Jitsuyo Shinan Toroku Koho    1996-2004
    Kokai Jitsuyo Shinan Koho  1971-2004    Toroku Jitsuyo Shinan Koho    1994-2004

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2002-299599 A  (Asahi Kasei Corp.),<br>11 October, 2002 (11.10.02),<br>Full text; Figs. 1 to 6<br>(Family: none) | 1-16 |
| Y | JP 2002-009364 A  (Murata Mfg. Co., Ltd.),<br>11 January, 2002 (11.01.02),<br>Par. Nos. [0014], [0025]<br>& EP 1168466 A2<br>Par. No. [0033]<br>& US 2002/0016048 A1<br>Par. No. [0037] | 1-16 |

☒ Further documents are listed in the continuation of Box C.          ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 06 May, 2004 (06.05.04) | 25 May, 2004 (25.05.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

| International application No. |
| --- |
| PCT/JP2004/002258 |

C (Continuation). DOCUMENTS CONSIDERED TO BE RELEVANT

| Category* | Citation of document, with indication, where appropriate, of the relevant passages | Relevant to claim No. |
| --- | --- | --- |
| Y | JP 7-249577 A (Matsushita Electric Industrial Co., Ltd.), 26 September, 1995 (26.09.95), Par. Nos. [0015], [0018]; Fig. 3 & US 5385864 A Column 5, lines 5 to 7; Fig. 3 | 1-16 |
| Y | JP 10-233539 A (Asahi Kasei Corp.), 02 September, 1998 (02.09.98), Par. No. [0008] & EP 0548375 A1 Page 4, lines 20 to 22 & US 5453727 A Column 2, line 66 to column 3, line 3 | 5,14 |

Form PCT/ISA/210 (continuation of second sheet) (January 2004)